# EUROPEAN PATENT APPLICATION

(11) **EP 2 801 805 A1**
(43) Date of publication of application: **12.11.2014**
(21) Application number: 13755133.9
(22) Date of filing: 27.02.2013
(51) Int. Cl.: G01L 9/00, H01L 23/02, H01L 29/84

(54) **PRESSURE SENSOR MODULE AND LID**

(30) Priority: 27.02.2012 JP 2012040167
(71) Applicant: Fujikura Ltd., Tokyo 135-8512 (JP)
(72) Inventor: TOMITA Michikazu, Sakura-shi Chiba 285-8550 (JP)
(74) Representative: Cabinet Plasseraud
(86) International application number: PCT/JP2013/055065
(87) International publication number: WO 2013/129444

(57) **Abstract**

A pressure sensor module of the invention includes: a substrate (2); a lid (3) connected to the substrate (2); a semiconductor pressure sensing device (10) and an integrated circuit device (20) functionally connected to the semiconductor pressure sensing device (10), which are accommodated in an internal space (C) surrounded by the substrate (2) and the lid (3); a pressure introducing hole (S1) that communicates the internal space (C) to an external space; and a light shield (R1) that is provided between the external space and the internal space (C) and is formed so that a hole axis of the pressure introducing hole (S1) is bent.

## Description

### TECHNICAL FIELD

The present invention relates to a pressure sensor module and a lid.

Particularly, the invention relates to a pressure sensor module into which a semiconductor pressure sensing device and an integrated circuit device functionally connected to the semiconductor pressure sensing device are packaged, and a lid used in the pressure sensor module.

This application claims priority from Japanese Patent Application No. 2012-040167 filed on February 27, 2012, the contents of which are incorporated herein by reference in their entirety.

### BACKGROUND ART

A semiconductor pressure sensing device (hereinbelow, referred to as a pressure sensing device) is a sensing device that has a function of converting a pressure change occurring on a semiconductor substrate such as silicon into a voltage signal by utilizing a diaphragm and a piezoresistance formed on a semiconductor substrate.

In the pressure sensor module, a semiconductor device such as a drive circuit device which is connected to a pressure sensing device or a pressure sensing device is mounted on a package substrate and such semiconductor device is covered with a lid.

A pressure introducing hole for introducing external pressure change into the inside of the module is provided in the lid.

For a small digital assistant such as a portable telephone, it is necessary to highly densely arrange a plurality of devices in a limited space inside a small housing.

As a pressure sensor module mounted on the foregoing small digital assistant, a pressure sensor module that reduces variation in vibration characteristics and realizes a thinning thereof is known (Patent Document 1).

On the other hand, a light emitting device (LED lamp or the like) serving as a backlight used in a liquid crystal display is packaged inside the housing of a small digital assistant such as a portable telephone.

Since the inside space of the housing is limited, it is necessary to arrange a light emitting device and a pressure sensor module close to each other in the inside of the housing.

For this reason, through the pressure introducing hole, the internal space of the pressure sensor module may be irradiated with light emitted from the light emitting device that is arranged close to the pressure sensor module.

In the case where a pressure sensing device or a drive circuit device which is packaged inside the pressure sensor module is irradiated with the light emitted from the light emitting device, photovoltaic power is generated inside such devices, and there is a concern that output characteristics of the pressure sensing device vary or the drive circuit device malfunctions.

### PRIOR ART DOCUMENTS

### PATENT DOCUMENTS

[Patent Document 1] Japanese Unexamined Patent Application, First Publication No. 2007-178133

### SUMMARY OF INVENTION

### PROBLEMS TO BE SOLVED BY THE INVENTION

The invention was conceived in view of the above-described circumstances and has an object thereof to provide a pressure sensor module that inhibits light from entering the inside of a pressure sensor module and can prevent a variation in the output characteristics or the faulty operation thereof and a lid used in the pressure sensor module.

### MEANS FOR SOLVING THE PROBLEMS

In order to solve the above-described problem, a pressure sensor module of a first aspect of the invention includes: a substrate; a lid connected to the substrate; a semiconductor pressure sensing device and an integrated circuit device functionally connected to the semiconductor pressure sensing device, which are accommodated in an internal space surrounded by the substrate and the lid; a pressure introducing hole that communicates the internal space to an external space; and a light shield that is provided between the external space and the internal space and is formed so that a hole axis of the pressure introducing hole is bent.

In the invention, the pressure introducing hole means not only "a hole provided inside a side wall constituting a lid" but also "a hole pathway formed by combining a member (a light shielding wall, a protrusion, a dividing wall, or the like) formed inside a space surrounded by a side wall constituting a lid and a hole provided inside a side wall".

Also, "a hole axis is bent" means that a pressure introducing hole is formed by a connection of at least two holes (a first hole and a second hole), and that a second hole axis along the direction in which the second hole extends is inclined with respect to a first hole axis along the direction in which the first hole extends.

According to the first aspect of the invention, since the pressure introducing hole includes the light shield that is between the external space and the internal space and that is formed by bending the hole axis of the pressure introducing hole, for example, light is prevented from entering the inside of the pressure sensor module from the external space through an opening of the pressure introducing hole which is communicated with and connected to the external space.

Consequently, a variation in the output characteristics of the pressure sensing device located inside the pressure sensor module or a malfunction such as a faulty operation of the integrated circuit device can be prevented.

In the pressure sensor module of the first aspect of the invention, it is preferable that an opening of the pressure introducing hole that opens to the internal space be located at a region that does not face a functional surface of the semiconductor pressure sensing device and the integrated circuit device.

According to the first aspect of the invention, even where light enters through the pressure introducing hole, functional surfaces of the semiconductor pressure sensing device and the integrated circuit device are not irradiated with light.

Because of this, a variation in the output characteristics of the pressure sensing device inside the pressure sensor module or a malfunction such as a faulty operation of the integrated circuit device can be prevented.

In the pressure sensor module of the first aspect of the invention, it is preferable that the pressure introducing hole be formed to the side of the pressure sensor module.

According to the first aspect of the invention, since the pressure introducing hole is formed to the side of the pressure sensor module, it is possible to realize a downsized pressure sensor module.

In the pressure sensor module of the first aspect of the invention, it is preferable that the lid have a through hole that communicates the external space to the internal space and a light shielding wall that is provided inside the lid and formed at a position facing the through hole.

According to the first aspect of the invention, since the pressure introducing hole is formed by the through hole and the light shielding wall, the functional surfaces of the semiconductor pressure sensing device and the integrated circuit device are not irradiated with light.

Because of this, a variation in the output characteristics of the pressure sensing device inside the pressure sensor module or a malfunction such as a faulty operation of the integrated circuit device can be prevented.

In the pressure sensor module of the first aspect of the invention, it is preferable that the lid have a first side wall and a second side wall, the through hole be provided in the first side wall, the light shielding wall be provided on the second side wall, and the pressure introducing hole be formed by the through hole and the light shielding wall.

According to the first aspect of the invention, since the pressure introducing hole is formed by the through hole provided in the first side wall and the light shielding wall provided on the second side wall, the functional surfaces of the semiconductor pressure sensing device and the integrated circuit device are not irradiated with light.

Accordingly, the same effect as that described above is obtained.

In the pressure sensor module of the first aspect of the invention, it is preferable that the light shielding wall be a protrusion that protrudes from the second side wall and that the protrusion be provided to cover the through hole provided on the first side wall.

According to the first aspect of the invention, since the protrusion covers the through hole, the functional surfaces of the semiconductor pressure sensing device and the integrated circuit device are not irradiated with light.

Accordingly, the same effect as that described above is obtained.

In the pressure sensor module of the first aspect of the invention, it is preferable that the lid have an upper wall, a hole inner surface on which the pressure introducing hole is formed, and a stepped portion provided between the upper wall and the hole inner surface.

According to the first aspect of the invention, since the stepped portion is provided, the pressure introducing hole is arranged separately from the functional surfaces of the semiconductor pressure sensing device and the integrated circuit device.

For this reason, even where light is incident to the through hole, it is difficult for light to reach the devices that are disposed in the internal space.

Accordingly, the same effect as that described above is obtained.

In the pressure sensor module of the first aspect of the invention, it is preferable that the color of an inner wall surface of the pressure introducing hole be black.

According to the first aspect of the invention, since the color of the inner wall surface of the pressure introducing hole is black, even if light is incident to the inside of the pressure sensor module from the external space, the incident light is prevented from scattering at the inner wall surface.

Therefore, a variation in the output characteristics of the pressure sensing device inside the pressure sensor module or a faulty operation of the integrated circuit device can be prevented.

A lid of a second aspect of the invention includes: a through hole that communicates an external space to an internal space; and a light shielding wall that is provided in the internal space and formed at a position facing the through hole.

The lid of the second aspect of the invention is used in the pressure sensor module of the aforementioned first aspect.

In the lid of the second aspect of the invention, it is preferable that the through hole be provided on the first side wall, the light shielding wall be provided on the second side wall, and a pressure introducing hole be formed by the through hole and the light shielding wall.

In the lid of the second aspect of the invention, it is preferable that the light shielding wall be a protrusion that protrudes from the second side wall and that the protrusion be provided to cover the through hole provided on the first side wall.

In the lid of the second aspect of the invention, it is preferable that the lid have an upper wall, a hole inner surface on which the pressure introducing hole is formed, and a stepped portion provided between the upper wall and the hole inner surface.

In the lid of the second aspect of the invention, it is preferable that the color of an inner wall surface of the pressure introducing hole is black.

### Effects of the Invention

According to the pressure sensor module according to the first aspect of the invention and the lid according to the second aspect, since the pressure introducing hole includes a light shield that is configured to block light with which the internal space of the pressure sensor module is irradiated, a variation in the output characteristics of the pressure sensing device or a faulty operation of the integrated circuit device can be prevented.

### BRIEF DESCRIPTION OF THE DRAWINGS

FIG. 1A is a vertical cross-sectional view schematically showing a configuration example 1 of a pressure sensor module according to the first embodiment of the invention.
FIG. 1B is a horizontal cross-sectional view schematically showing the configuration example 1 of the pressure sensor module according to the first embodiment of the invention.
FIG. 2 is a diagram showing an electrical configuration of a gauge resistor.
FIG. 3A is a vertical cross-sectional view schematically showing a configuration example 2 of the pressure sensor module according to the first embodiment of the invention.
FIG. 3B is a horizontal cross-sectional view schematically showing the configuration example 2 of the pressure sensor module according to the first embodiment of the invention.
FIG. 4A is a vertical cross-sectional view schematically showing a configuration example 3 of the pressure sensor module according to the first embodiment of the invention.
FIG. 4B is a horizontal cross-sectional view schematically showing the configuration example 3 of the pressure sensor module according to the first embodiment of the invention.
FIG. 5A is a vertical cross-sectional view schematically showing a configuration example 1 of a pressure sensor module according to the second embodiment of the invention.
FIG. 5B is a horizontal cross-sectional view schematically showing the configuration example 1 of the pressure sensor module according to the second embodiment of the invention.
FIG. 6A is a vertical cross-sectional view schematically showing a configuration example 2 of the pressure sensor module according to the second embodiment of the invention.
FIG. 6B is a horizontal cross-sectional view schematically showing the configuration example 2 of the pressure sensor module according to the second embodiment of the invention.
FIG. 7A is a vertical cross-sectional view schematically showing a configuration example 4 of a pressure sensor module according to the first embodiment of the invention.
FIG. 7B is an enlarged cross-sectional view schematically showing the configuration example 4 of the pressure sensor module according to the first embodiment of the invention and taken along the line A-A' of the portion indicated by reference letter Z shown in FIG. 7A.
FIG. 7C is a horizontal cross-sectional view schematically showing the configuration example 4 of the pressure sensor module according to the first embodiment of the invention.
FIG. 8A is a plan view showing the inside of a lid constituting a pressure sensor module according to the third embodiment of the invention.
FIG. 8B is a cross-sectional view showing the inside of the lid constituting the pressure sensor module according to the third embodiment of the invention and taken along the line B-B' shown in FIG. 8A.
FIG. 8C is a plan view showing the outside of the lid constituting the pressure sensor module according to the third embodiment of the invention.
FIG. 9A is an enlarged plan view showing a corner inside the lid constituting the pressure sensor module according to the third embodiment of the invention.
FIG. 9B is a cross-sectional view showing the pressure sensor module according to the third embodiment of the invention.
FIG. 10A is an enlarged plan view showing the inside of a modified example 1 of the lid constituting the pressure sensor module according to the third embodiment of the invention.
FIG. 10B is an enlarged plan view showing the inside of a modified example 2 of the lid constituting the pressure sensor module according to the third embodiment of the invention.
FIG. 10C is an enlarged plan view showing the inside of a modified example 3 of the lid constituting the pressure sensor module according to the third embodiment of the invention.
FIG. 10D is an enlarged plan view showing the inside of a modified example 4 of the lid constituting the pressure sensor module according to the third embodiment of the invention.

### EMBODIMENTS FOR CARRYING OUT THE INVENTION

Next, the invention will be particularly described based on embodiments described below with reference to drawings; however, the invention is not limited to the embodiments.

In these drawings which are utilized in the following explanation, appropriate changes have been made in the scale of the various members, in order to represent them at scales at which they can be easily understood.

### <First Embodiment>

### (1) Configuration of Pressure Sensor Module

Hereinafter, the first embodiment according to the invention will be described with reference to drawings.

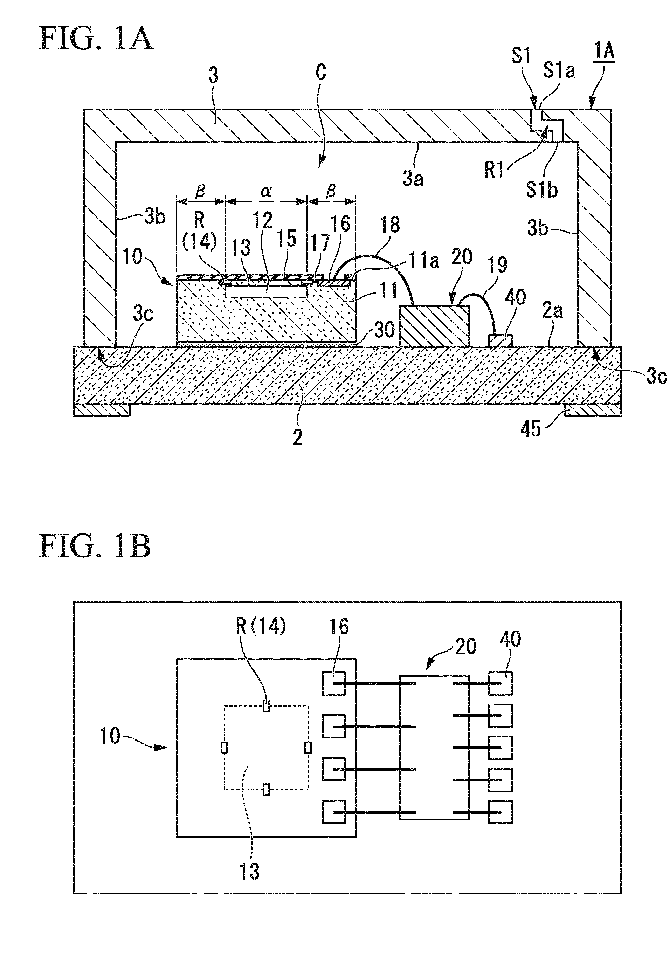

FIGS. 1A and 1B are schematic views showing one configuration example of a pressure sensor module according to the embodiment, FIG. 1A is a vertical cross-sectional view, and FIG. 1B is a horizontal cross-sectional view.

A pressure sensor module 1A has an internal space C defined by a package substrate 2 and a lid 3.

A pressure sensing device 10 and an integrated circuit device 20 (signal processing IC) for controlling the drive of the pressure sensing device 10 are arranged above the package substrate 2 in the internal space C.

The internal space C is communicated with the external space of the pressure sensor module 1A through the pressure introducing hole S1 (S2).

The pressure introducing hole S1 (S2) is arranged so as to face a region other than the region of the package substrate 2 on which the pressure sensing device 10 and the integrated circuit device 20 (signal processing IC) used to control the drive of the pressure sensing device 10 are arranged.

The pressure introducing hole S1 (S2) has a light shield R1 (R2) which is formed between the external space and the internal space so that the hole axis of the pressure introducing hole (communicating hole, ventilation hole) is bent.

Here, "the hole axis of the pressure introducing hole is bent" means that the extending direction of the pressure introducing hole is converted into a direction which is not straight.

In other words, in the case where it is thought that a pressure introducing hole is formed by connection of at least two holes (a first hole and a second hole), the second hole axis along which the second hole extends is inclined with respect to the first hole axis along which the first hole extends.

That is, "bend" of the invention also includes a snaking or reversing configuration in addition to a curved or flectional configuration.

### (1.1) Configuration of Pressure Sensing Device

The pressure sensing device 10 that configures the pressure sensor module 1A uses a flat plate-shaped semiconductor substrate 11 as a base member, and a pressure detector for detecting a pressure is formed on one face 11a of the semiconductor substrate 11.

At a center region α of one face 11a of the semiconductor substrate 11, a space 12 (pressure reference chamber) that is substantially parallel to one surface 11a and that spreads in the internal side in the substrate thickness direction, and a diaphragm 13 that is located above the space 12 and that has a reduced thickness are provided.

Furthermore, a plurality of gauge resistances 14 are arranged at an outer edge of the diaphragm 13.

The pressure detector is constituted by the space 12 (pressure reference chamber), the diaphragm 13, and the gauge resistances 14.

On one face 11a of the semiconductor substrate 11, first connection pads 16 which are electrically connected to the gauge resistances 14 are arranged on the outer edge region β on which the diaphragm 13 is excepted.

A plurality of the first connection pads 16 are arranged so that the first connection pads 16 are connected to each other via a pad-connecting wire 17 interposed therebetween.

For this reason, the first connection pads are configured to be connected to each other via the gauge resistor 14 and the pad-connecting wire 17.

Moreover, an insulating layer 15 is provided on the region on one face 11a of the semiconductor substrate 11 on which the first connection pads 16 are excepted, and the insulating layer blocks the gauge resistor 14 from coming in contact with the external air and protects the gauge resistor 14 from contaminants.

Four gauge resistors 14 (R1 to R4) serving as a pressure-sensitive device are arranged on one face 11a of the semiconductor substrate 11.

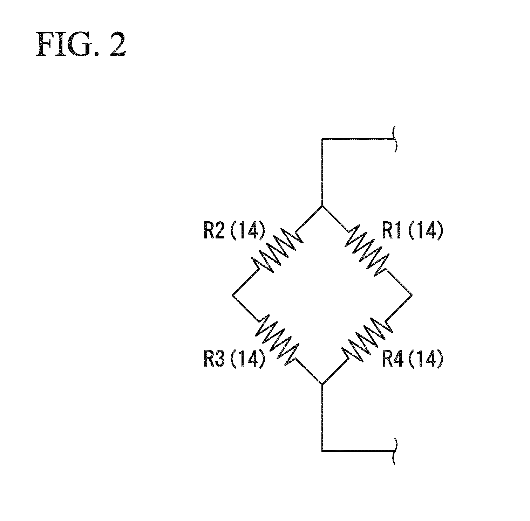

The gauge resistors 14 are electrically connected to each other via lead wirings or the like (not shown in the figure) so as to configure a so-called Wheatstone bridge circuit (refer to FIG. 2).

### (1.2) Configuration of Package Substrate

The package substrate 2 is formed of, for example, ceramic materials such as alumina (Al₂O₃) or synthetic resin materials such as epoxy resins or polyimide resin.

A plurality of bonding pads 40 on which connecting wires 19 electrically connecting the pressure sensing device 10 to the package substrate 2 are fixed and external connection electrodes 45 that are electrically connected to such bonding pads 40 and are used at the time of packaging the package substrate 2 are arranged on the package substrate 2.

Particularly, the bonding pads 40 and the external connection electrodes 45 are configured as a layered body onto which metal materials such as nickel (Ni), chrome (Cr), copper (Cu), gold (Au) are combined.

The pressure sensing device 10 and the integrated circuit device 20 (signal processing IC) used to control the drive of the pressure sensing device 10 are arranged on one face 2a of the package substrate 2 with an adhesive layer 30 made of an adhesive interposed therebetween.

As the adhesive, for example, an adhesive made of epoxy resins, silicone resin, or the like, or a metal material such as silver (Ag) may be used.

Moreover, the first connection pads 16 of the pressure sensing device 10 are electrically connected to the integrated circuit device 20 (signal processing IC) used to control the drive of the pressure sensing device 10 with connecting wires 18 interposed therebetween.

Furthermore, the integrated circuit device 20 (signal processing IC) used to control the drive of the pressure sensing device 10 is electrically connected to bonding pads 40 with the connecting wires 19 interposed therebetween.

The connection is carried out by wire bonding using a metal wiring made of, for example, gold (Au), aluminum (Al), or copper (Cu); however, flip chip interconnection may be adopted by use of a bump made of, for example, gold (Au) or a solder material.

### (1.3) Configuration of Lid

The lid 3 has an opening located at one end, an upper wall 3a and side walls 3b which are closed and located at the other end, and a bottom 3c located at the periphery of the opening.

The bottom 3c is attached to one face 2a of the package substrate 2 via an adhesive layer made of adhesive.

That is, the lid 3 is configured to cover the pressure sensing device 10 and the integrated circuit device 20 (signal processing IC) used to control the drive of the pressure sensing device 10 with the internal space C interposed therebetween.

As the adhesive, for example, an adhesive made of epoxy resins, silicone resin, or the like, or a metal material may be used as an example.

The lid 3 can be formed of synthetic resin materials such as epoxy resins or polyphenylene sulfide (PPS) by injection molding.

In addition, it is preferable that the lid 3 include a light impermeable material and be made of a black resin material.

### (1.4) Configuration of Pressure introducing hole

The pressure introducing hole S1 is formed on the upper wall 3a of the lid 3, and the internal space C is communicated with the external space.

Furthermore, as shown in FIG. 1A, the pressure introducing hole S1 is positioned so that a hole axis of an opening S1a that is communicated with and connected to the external space and a hole axis of an opening S1b that is communicated with and connected to the internal space C are bent.

The pressure introducing hole S1 having the bent hole axes is formed to have L-shaped cross-sectional configurations facing each other and are formed to include a light shield R1 that shields light from entering from the external space.

Additionally, the opening S1a of the pressure introducing hole S1 which is communicated with and connected to the external space and the opening S1b thereof which is communicated with and connected to the internal space C are arranged at positions where they do not overlap each other when seen in a plan view.

Moreover, the position (the opening S1b) of the pressure introducing hole S1 which faces the internal space C is located so as to face a region other than the region of the substrate 2 on which the pressure sensing device 10 and the integrated circuit device 20 (signal processing IC) used to control the drive of the pressure sensing device 10 are arranged.

Specifically, the opening S1b that is communicated with and connected to the internal space C is formed to face a region other than the region on which the pressure sensing device 10 disposed on the package substrate 2 and the integrated circuit device 20 (signal processing IC) used to control the drive of the pressure sensing device 10 are arranged.

Furthermore, it is preferable that the opening S1b be formed to face a region other than the region on which the bonding pads 40 are arranged.

As a result of arranging the opening S1b as stated above, even where light enters the inside of the internal space C through the pressure introducing hole, the pressure sensing device 10, the integrated circuit device 20, or the bonding pads 40 are not irradiated with light.

As a result, a variation in the output characteristics of the pressure sensing device or a faulty operation of the integrated circuit device can be prevented.

In other cases, the pressure introducing hole S1 is not limited to the upper wall 3a of the lid 3, it is only necessary to arrange the lid 3 so that the hole axis of the opening S1a that is communicated with and connected to the external space and the hole axis of the opening S1b that is communicated with and connected to the internal space C are bent.

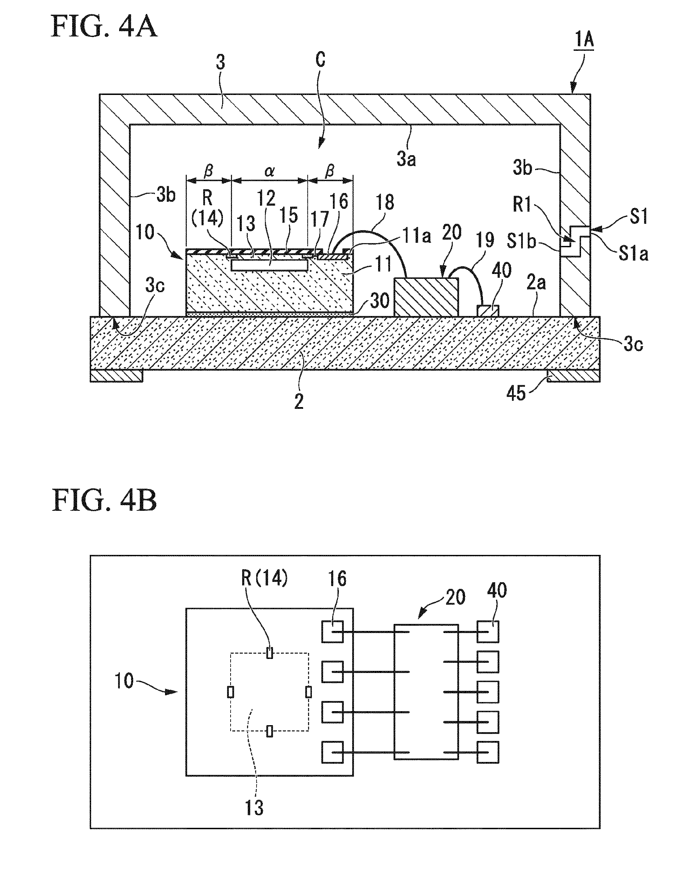

For example, as shown in FIGS. 4A and 4B, a constitution may be adopted in which the pressure introducing hole S1 is formed on the side wall 3b of the lid 3 which constitutes a lateral portion of the pressure sensor module.

As a result of forming the pressure introducing hole S1 on the side wall 3b of the lid 3, it is not necessary to provide a region, on which the pressure introducing hole S1 is to be formed, on the upper wall 3a of the lid 3 or the package substrate 2.

Consequently, the size of the lid 3or the package substrate in the planar direction is reduced, and as a result, a reduction of the entire pressure sensor module in size is easily achieved.

Moreover, even where light enters the internal space through the pressure introducing hole S1 formed on the lateral portion of the pressure sensor module (the side wall of the lid), the portion that is mainly irradiated with the incident light is the side surface of the pressure sensing device 10 or the integrated circuit device 20, the surface on which the diaphragm or the pressure-sensitive device is formed is less likely to be directly irradiated with light.

For this reason, a variation in the characteristics of the pressure sensing device 10 or a faulty operation of the integrated circuit device 20 can be reduced.

As shown in FIGS. 4A and 4B, in the pressure introducing hole S1 arranged at the lateral portion of the pressure sensor module, that is, in the pressure introducing hole S1 arranged at the side wall 3b of the lid 3, it is preferable that the opening S1b communicated with and connected to the internal space C be formed at the position lower than the position of the functional surface of the pressure sensing device 10 or the integrated circuit device 20 which is arranged in the internal space C (positional relationship of the pressure sensor module in a vertical direction).

By means of this structure, even where light enters the internal space through the pressure introducing hole S1, a possibility of directly irradiating the functional surface of the pressure sensing device 10 or the integrated circuit device 20 with incident light is eliminated.

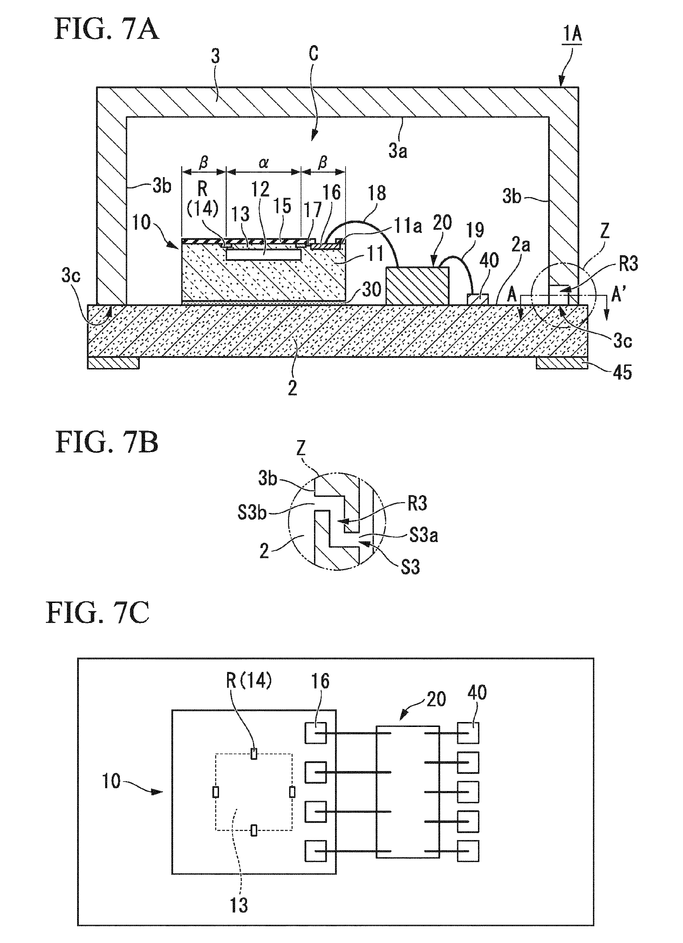

Particularly, from among configuration examples of the pressure introducing hole S1 provided at the lateral portion of the pressure sensor module, it is preferable to adopt a constitution shown in FIGS. 7A, 7B, and 7C in which the pressure introducing hole S1 is only formed at the lower end of the side wall 3b of the lid 3.

In this configuration, it is more preferable to that the upper surface of the package substrate 2 be flat which is arranged at the position opposed to the lower end of the side wall 3b.

FIG. 7B is an enlarged cross-sectional view (inside of the circle shown by a dotted line) which is taken along the line A-A' of the portion indicated by reference letter Z of FIG. 7A. Particularly, as shown in FIG. 7B, the inner wall of the pressure introducing hole S1 formed at the lower end of the lid 3 is configured by the lid 3 (upper surface, side surface) and the package substrate 2 (lower surface).

As a result of using the constitution shown in FIGS. 7A, 7B, and 7C, that is, the configuration having the pressure introducing hole S1 located at the side wall 3b of the lower end of the lid 3, since it is possible to easily form the lid 3 by an injection molding method or the like, it is possible to provide a pressure sensor module which can be inexpensively manufactured with excellent design freedom.

In the configuration example shown in FIG. 1A, both ends of the light shield R1 are bending points and the pressure introducing holes S1 are formed to extend straight toward two openings S1a and S1b from the respective bending points. However, the invention is not limited to this configuration example.

As long as, for example, the hole axis is bent (has a bending point), the bending point may form a light shield.

As the configuration example, a configuration may be adopted which provides a bending point that causes a linearly-extended pressure introducing hole to reverse direction at a desired angle.

Additionally, a configuration may be employed which provides one light shield having three or more bending points.

As the configuration example, a configuration may be adopted which provides a light shield formed in an S-shaped way and thereby includes a plurality of bending points.

The pressure introducing hole S1 is formed integrally with the lid 3 by injection molding or the like.

Particularly, the pressure introducing hole S1 is formed as part of the lid 3 having a black light shielding portion R1 by using a resin material containing a light impermeable material, such as, for example, a black resin material.

Moreover, the inner wall of the pressure introducing hole S1 can be made black by coating it with, for example, a black coating material.

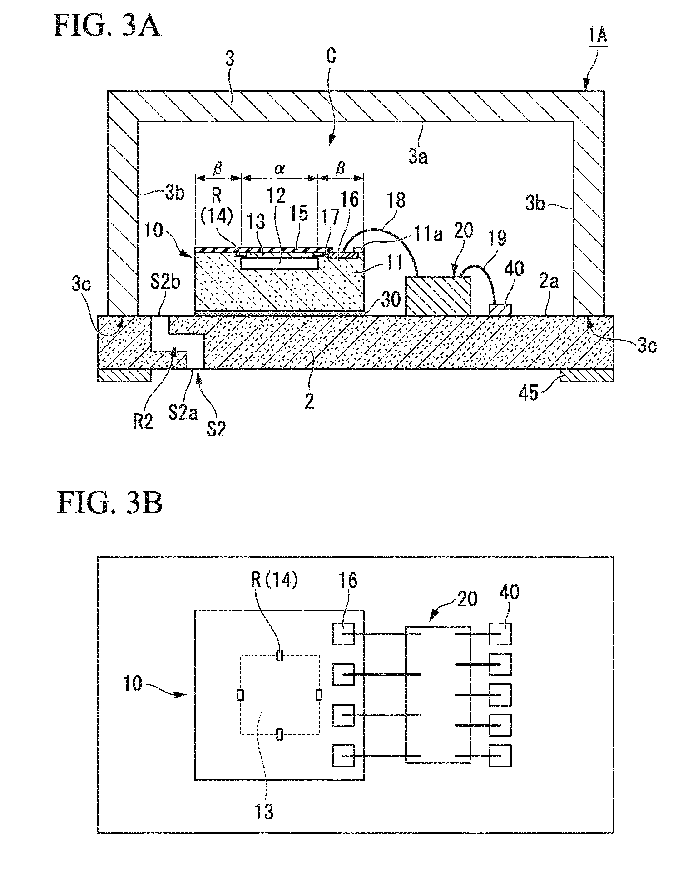

Furthermore, as shown in FIGS. 3A and 3B, a pressure introducing hole S2 can be provided at the package substrate 2.

Specifically, in a way similar to the case of forming the pressure introducing hole at the lid 3, the pressure introducing hole S2 is positioned so that a hole axis of an opening S2a of the package substrate 2 which is communicated with and connected to the external space and a hole axis of an opening S2b thereof which is communicated with and connected to the internal space C are bent.

The pressure introducing hole S2 having the bent hole axes is formed to have L-shaped cross-sectional configurations facing each other and are formed to include a light shield R2 that shields light from entering from the external space.

Moreover, the opening S2b of the pressure introducing hole S2 which is communicated with and connected to the internal space C is located at a region other than the region of the package substrate 2 on which the pressure sensing device 10 and the integrated circuit device 20 (signal processing IC) used to control the drive of the pressure sensing device 10 are arranged.

Furthermore, the inner wall surface of the pressure introducing hole S2 is preferably made black by the use of, for example, a black coating material.

### (3) Action and Effect

In the pressure sensor module 1A according to the embodiment, the pressure sensing device 10 and the integrated circuit device 20 (signal processing IC) used to control the drive of the pressure sensing device 10 are arranged in the internal space C surrounded by the package substrate 2 and the lid 3 connected to the package substrate 2.

The internal space C is communicated with the external space of the pressure sensor module 1A through the pressure introducing hole S1 (S2).

The pressure introducing hole S1 (S2) is arranged so as to face a region other than the region of the package substrate 2 on which the pressure sensing device 10 and the integrated circuit device 20 (signal processing IC) used to control the drive of the pressure sensing device 10 are arranged.

In addition, the light shield R1 (R2) is positioned between the external space and the internal space C so that the hole axis of the opening S1a (S2a) that is communicated with and connected to the external space and the hole axis of the opening S1b (S2b) that is communicated with and connected to the internal space C are bent.

The light shield R1 (R2) is formed so that it is difficult for light to enter the internal space C from the external space through the pressure introducing hole S1 (S2).

Even where the light emitted from the light emitting device that is arranged close to the pressure sensor module 1A (for example, an LED) is incident to the opening S1a (S2a) of the pressure introducing hole S1 (S2) which is communicated with and connected to the external space, since the light shield R1 (R2) which is formed to have L-shaped cross-sectional configurations facing each other is provided, the light is prevented from entering the internal space C through the opening S1b (S2b) that is communicated with and connected to the internal space C.

Accordingly, there is not a concern that the pressure sensing device 10 and the integrated circuit device 20 (signal processing IC) used to control the drive of the pressure sensing device 10 which are arranged on the substrate 2 in the pressure sensor module 1A are irradiated with light.

Furthermore, even where extraneous materials enter from the external space, it is difficult for the extraneous materials to directly reach the pressure sensing device 10, the integrated circuit device 20 (signal processing IC) used to control the drive of the pressure sensing device 10, and the like which are on the package substrate 2.

Moreover, when light is incident to the inner wall surface from the external space, since the inner wall surface of the pressure introducing hole S1 (S2) is black, the incident light is prevented from scattering, and therefore, there is not a concern that the pressure sensing device 10 and an integrated circuit device 20 (ASIC) used to control the drive of the pressure sensing device 10 are irradiated with light.

Consequently, a problem of a variation in the output characteristics of the pressure sensing device 10 or a faulty operation of the integrated circuit device 20 (ASIC) used to control the drive of the pressure sensing device 10 can be solved.

### <Second Embodiment>

Hereinafter, the second embodiment according to the invention will be described with reference to drawings.

Particularly, in the second embodiment, identical symbols are used for the elements which are identical to those of the first embodiment, and the explanations thereof are omitted, and only elements different therefrom will be described here.

### (1) Configuration of Pressure Sensor Module

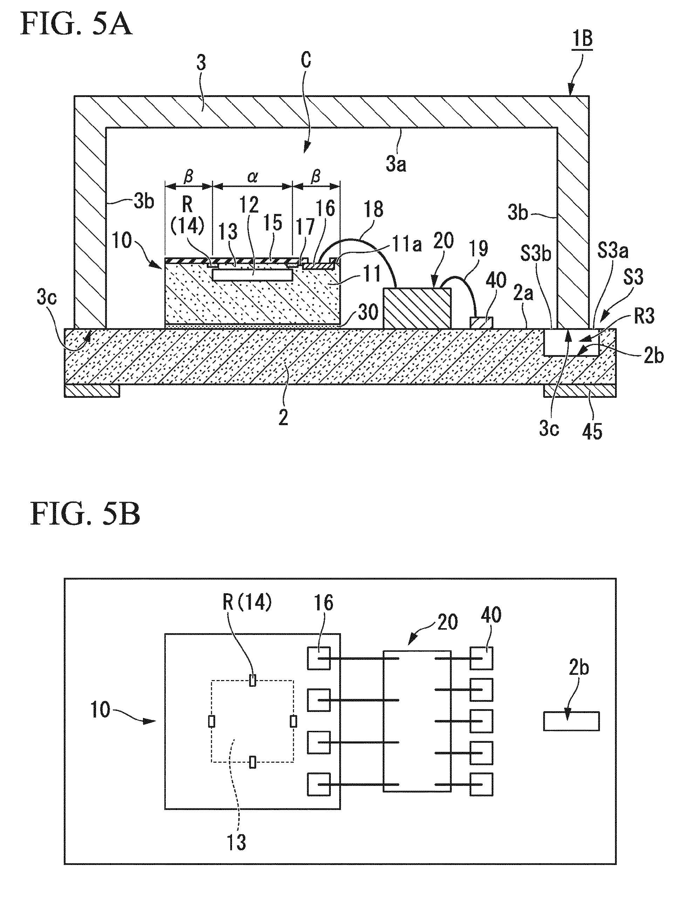

FIGS. 5A and 5B are schematic views showing one configuration example of a pressure sensor module 1B according to the embodiment, FIG. 5A is a vertical cross-sectional view, and FIG. 5B is a horizontal cross-sectional view.

A pressure sensor module 1B has an internal space C defined by a package substrate 2 and a lid 3.

A pressure sensing device 10 and an integrated circuit device 20 (signal processing IC) for controlling the drive of the pressure sensing device 10 are arranged above the package substrate 2 in the internal space C.

The internal space C is communicated with the external space of the pressure sensor module 1B through a pressure introducing hole S3; however, it is different from the first embodiment in that the pressure introducing hole S3 is formed by the package substrate 2 and the lid 3.

### (1.1) Configuration of Package Substrate

Similar to the first embodiment, the package substrate 2 is formed of, for example, ceramic materials such as alumina (Al₂O₃) or synthetic resin materials such as epoxy resins or polyimide resin.

A plurality of bonding pads 40 on which ends of metal wirings 19 electrically connecting the pressure sensing device 10 to the package substrate 2 are fixed and external connection electrodes 45 that is electrically connected to the bonding pads 40 and is used at the time of packaging the package substrate 2 are arranged on the package substrate 2.

Particularly, the bonding pads 40 and the external connection electrodes 45 are configured as a layered body to which metal materials such as nickel (Ni), chrome (Cr), copper (Cu), gold (Au) are combined.

Similar to the first embodiment, the pressure sensing device 10 and the integrated circuit device 20 (signal processing IC) used to control the drive of the pressure sensing device 10 are disposed on one face 2a of the package substrate 2 via the adhesive layer 30 made of adhesive.

One face 2a of the package substrate 2 is attached to the bottom 3c provided at the position close to the opening of the lid 3 via an adhesive layer made of adhesive.

Recess 2b is provided on one face 2a at part of the peripheral edge of one face 2a.

The recess 2b is located so as to face the bottom 3c close to the opening of the lid 3, and the pressure introducing holes S3 are thereby formed.

The pressure introducing hole S3 includes a light shield R3 that is positioned so that a hole axis of an opening S3a that is communicated with and connected to the external space and a hole axis of an opening S3b that is communicated with and connected to the internal space side C are bent; and the light shield is formed by the recess 2b provided at the peripheral edge of the package substrate 2 and the bottom 3c close to the opening of the lid 3 such that the internal space cannot be visually recognized from the external space.

### (1.2) Configuration of Pressure introducing hole

The pressure introducing hole S3 of the pressure sensor module 1B according to the embodiment is formed to open at the lateral portion other than the above and the bottom of the pressure sensor module 1B.

Particularly, the recess 2b is provided at the part of the peripheral edge of one face 2a of the package substrate 2 and the recess 2b is formed to face the bottom 3c close to the opening of the lid 3.

The position of the pressure introducing hole S3 is at the peripheral edge of one face 2a of the package substrate 2; as long as the position is opposed to the bottom 3c close to the opening of the lid 3, it is not particularly limited to this.

Furthermore, a plurality of pressure introducing hole S3 may be provided.

Additionally, the surfaces of the inner wall surface of the recess 2b and the bottom 3c of the lid 3 which faces the recess 2b are preferably made black by coating them with, for example, a black coating material or the like.

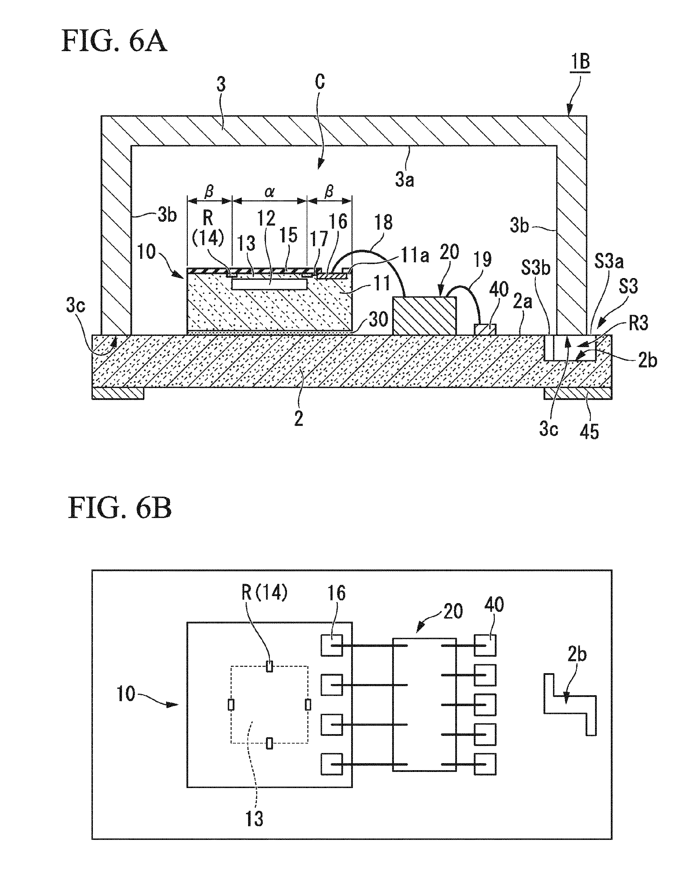

Moreover, FIGS. 6A and 6B show an example of the pressure introducing hole S3 which is formed at the lateral portion of the pressure sensor module and has a configuration different from the aforementioned configuration.

As shown in FIG. 6B, when seen in a plan view, the recess 2b of the package substrate 2 which forms the pressure introducing hole S3 may be formed in a key shape.

As a result of forming the pressure introducing hole in a key shape, it is difficult for the extraneous materials to directly reach the pressure sensing device 10, the integrated circuit device 20 (signal processing IC) used to control the drive of the pressure sensing device 10, and the like which are on the package substrate 2.

### (2) Action and Effect

In the pressure sensor module 1B according to the embodiment, the pressure sensing device 10 and the integrated circuit device 20 (signal processing IC) used to control the drive of the pressure sensing device 10 are arranged in the internal space C surrounded by the package substrate 2 and the lid 3 connected to the package substrate 2.

The internal space C is communicated with the external space of the pressure sensor module 1B through the pressure introducing hole S3 that is formed at the lateral portion of the pressure sensor module.

The pressure introducing hole S3 is configured by the recess 2b provided at the part of the peripheral edge of one face 2a of the package substrate 2 and the bottom 3c close to the opening of the lid 3.

In the case where the light emitted from the light emitting device (for example, LED) that is arranged close to the pressure sensor module 1B is incident to the opening S3a of the pressure introducing hole S3 which is communicated with and connected to the external space, the incident light is interrupted by the light shield R3 formed by the recess 2b provided at the part of the peripheral edge of one face 2a of the package substrate 2 and the bottom 3c close to the opening of the lid 3, and the light is blocked from entering the internal space C through the opening S3b that is communicated with and connected to the internal space C.

Accordingly, there is not a concern that the pressure sensing device 10 and the integrated circuit device 20 (signal processing IC) used to control the drive of the pressure sensing device 10 which are arranged on the substrate 2 in the pressure sensor module 1B are irradiated with light.

Furthermore, even where extraneous materials enter from the external space, it is difficult for the extraneous materials to directly reach the pressure sensing device 10, the integrated circuit device 20 (signal processing IC) used to control the drive of the pressure sensing device 10, and the like which are on the package substrate 2.

Furthermore, when light is incident to the inner wall surface from the external space, since the inner wall surface of the pressure introducing hole S3 is black, the incident light is prevented from scattering.

Therefore, there is not a concern that the pressure sensing device 10 and the integrated circuit device 20 (signal processing IC) used to control the drive of the pressure sensing device 10 are irradiated with light.

Consequently, a problem of a variation in the output characteristics of the pressure sensing device 10 or a faulty operation of the integrated circuit device 20 (signal processing IC) used to control the drive of the pressure sensing device 10 can be solved.

For example, the arrangement of the gauge resistor 14 may be modified depending on specification. Regarding the arrangement of the bonding pads 40 and the external connection electrodes 45, similarly, various modified examples may be considered.

### <Third Embodiment>

In the aforementioned first embodiment, the constitution is described in which the pressure introducing hole is formed inside the side wall 3b, the hole axis of the pressure introducing hole is bent, and the light shield is provided with the configurations that are formed to have L-shaped cross-sectional configurations facing each other.

Hereinafter, an embodiment will be described as a third embodiment which is different from the first embodiment in which the pressure introducing hole and the light shield are explained.

In the third embodiment, identical symbols are used for the elements which are identical to those of the above-described first and second embodiments, and the explanations thereof are omitted or simplified here.

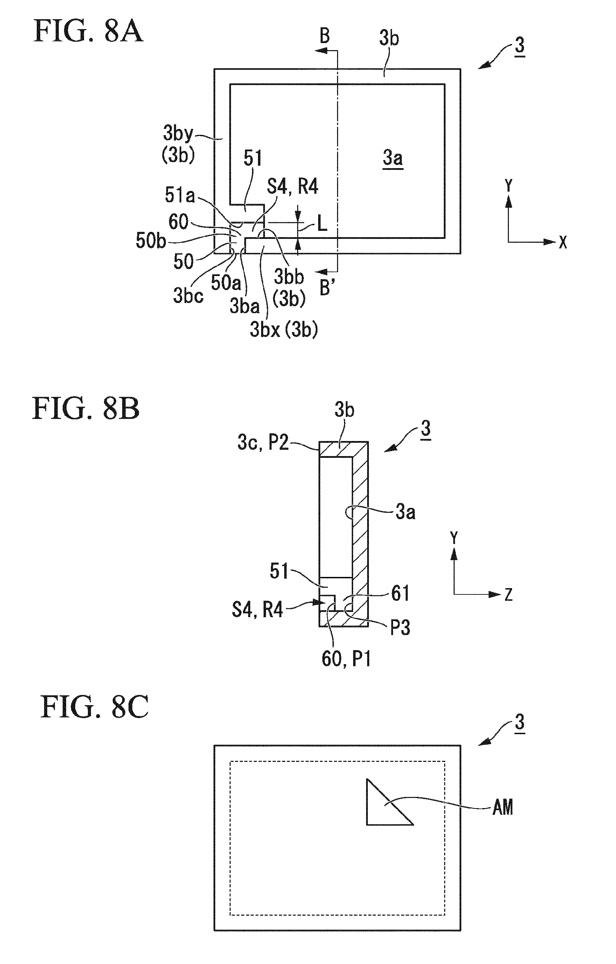

FIG. 8A is a plan view showing the internal side of a lid 3 forming a pressure sensor module according to a third embodiment.

As shown in FIG. 8A, in the lid 3 forming the pressure sensor module, a pressure introducing hole and a light shield are not formed inside the side wall 3b, and a pressure introducing hole S4 and a light shield R4 are formed by the through hole and protrusions which are provided at the side walls.

Particularly, as shown in FIG. 8A, the side walls 3b are configured by a side wall 3bx (first side wall) extending in the X-direction and a side wall 3by (second side wall) extending in the Y-direction.

A through hole 50 that communicates the internal space C defined by the package substrate 2 and the lid 3 to the external space of the lid 3 is provided at the side wall 3bx.

The through hole 50 has an opening 50a of the through hole 50 which is communicated with and connected to the external space and an opening 50b of the through hole 50 which is communicated with and connected to the internal space C.

Additionally, the side wall 3bx has a front-end face 3ba that is exposed to the through hole 50 and a side wall inner surface 3bb that is adjacent to the front-end face 3ba and extends in the X-direction.

Therefore, the through hole 50 is a space sandwiched between a front-end inner surface 3bc of the side wall 3by and the front-end face 3ba and extends in the Y-direction.

The width of the through hole 50 is approximately 200 µm

A protrusion 51 (light shielding wall) that extends parallel to the extending direction of the side wall 3bx is provided on the side wall 3by inside the internal space C.

The protrusion 51 protrudes from the side wall 3by and has a wall surface 51a.

The protrusion 51 protrudes from the side wall 3by so that the wall surface 51a faces the opening 50b (the through hole 50) and the side wall inner surface 3bb.

That is, the protrusion 51 is provided at the position at which it faces the through hole 50.

The space that is sandwiched between the wall surface 51a and the side wall inner surface 3bb extends in the X-direction.

By means of this structure, in the Y-direction inside the internal space C, the protrusion 51 is provided so as to cover the through hole 50, and the protrusion 51 protrudes from the side wall 3b toward the inside of the internal space C so that the wall surface 51a overlaps the side wall inner surface 3bb.

It is preferable that the distance L between the side wall inner surface 3bb (the opening 50b) and the wall surface 51a be approximately 200 µm.

In addition, it is preferable that the width of the protrusion 51 be approximately 200 µm.

As shown in FIG. 8A, the foregoing the protrusion 51 and the through hole 50 is provided close to a corner of the lid 3.

In other words, the protrusion 51 and the through hole 50 is provided adjacent to the intersection of the X-virtual line which extends in the X-direction so that the side wall 3b extends in this direction and the Y-virtual line which extends in the Y-direction so that the side wall 3by extends in this direction.

Since the corner is provided at the position apart from the region at which the pressure sensing device 10 and the integrated circuit device 20 are arranged, it is a preferable portion serving as the position at which the pressure introducing hole S4 and the light shield R4 are provided.

The pressure introducing hole S4 is configured by the through hole 50 and the space sandwiched between the wall surface 51a and the side wall inner surface 3bb which are formed as stated above.

Furthermore, since the space sandwiched between the wall surface 51a and the side wall inner surface 3bb extends in the X-direction and the through hole 50 extends in the Y-direction, the hole axis of the pressure introducing hole S4 is bent, and the light shield R4 is thereby formed.

As a result of setting the width of the through hole 50, the distance L, and the width of the protrusion 51 to be approximately 200 µm as described above, it is possible to cause heated and melted resin to easily flow into a die when the lid 3 is formed by injection molding and it is possible to reliably form the lid 3 with a desired shape.

Moreover, the protrusion 51 may be formed so that the width of the protrusion 51 becomes 200 µm or more; however, if this width is excessively large, there is a concern that the protrusion interferes with the pressure sensing device 10 and the integrated circuit device 20 which are arranged in the internal space C defined by the package substrate 2 and the lid 3.

Consequently, the width of the protrusion 51 is adequately determined so that a desired space is formed in the internal space C depending on the size or the arrangement (layout) of the pressure sensing device 10 and the integrated circuit device 20.

Furthermore, the lid 3 may be formed so that the width of the through hole 50 and the distance L becomes approximately 200 µm or more; however, in order to narrow the width of the optical path of the light entering the inside from the outside of the lid 3, it is preferable that the width of the through hole 50 and the distance L be approximately 200 µm.

Additionally, the portions including the through hole 50 and the protrusion 51 which are provided at the lid 3 are integrally formed by injection molding during formation of the lid 3.

Because of this, it is possible to simply produce the lid 3 having the above-mentioned configuration without requiring a plurality of steps to form the through hole 50 and the protrusion 51.

FIG. 8B is a cross-sectional view taken along the line B-B' shown in FIG. 8A, showing the inside of the lid 3 of the third embodiment.

As shown in FIG. 8B, the position P1 of the hole inner surface 60 on which the pressure introducing hole S4 and the light shield R4 are formed is different from the position P2 of the bottom 3c in the vertical direction of the lid 3 (Z-direction).

In other words, a stepped portion 61 is provided between the position P3 of the upper wall 3a and the position P1 of the hole inner surface 60.

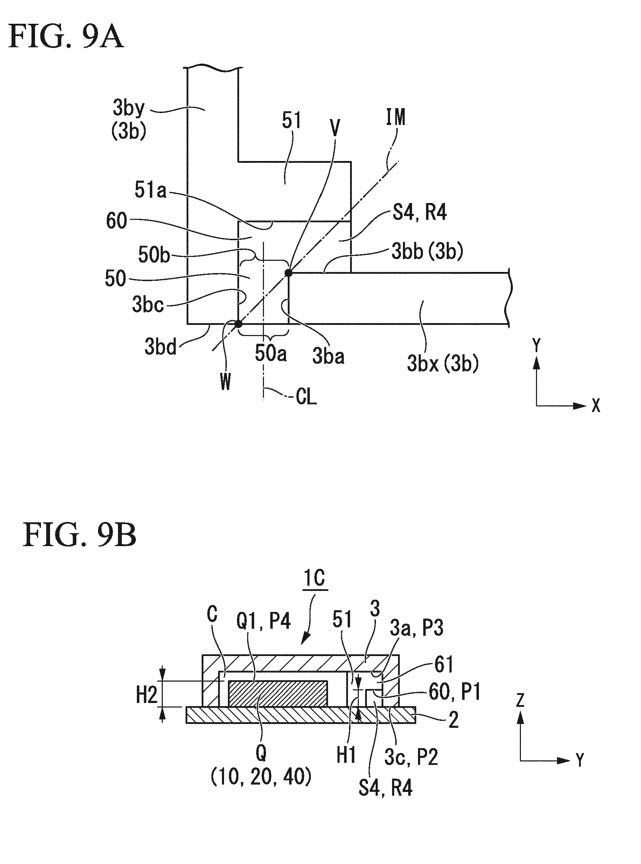

As a result of forming the stepped portion 61 between the hole inner surface 60 and the upper wall 3a in the lid 3 as stated above, even where light enters the opening 50a of the through hole 50 as will be particularly described in FIG. 9B, it is difficult for the light to reach the devices which are arranged in the internal space C.

Particularly, the distance between the position P1 and the position P2 in the Z-direction is, for example, 200 µm.

The distance between the position P2 and the position P3 is, for example, 450 µm.

FIG. 8C is a plan view showing the outside of the lid 3 forming a pressure sensor module according to the third embodiment.

In order to easily recognize the alignment direction of the lid 3 relative to the package substrate 2, an alignment mark AM is provided on the external surface of the lid 3.

The alignment mark AM is formed on the external surface of the lid 3 so as to be depressed.

Next, with reference to FIG. 9A, the structure of the corner of the lid 3 shown in FIG. 8A will be particularly described.

The opening 50a of the through hole 50 (outer opening) which is communicated with and connected to the external space is a region that extends in the X-direction and is formed between the front-end face 3ba of the side wall 3bx and the point W at which the front-end inner surface 3bc of the side wall 3by intersects with the front-end outer surface 3bd of the side wall 3by.

The opening 50b of the through hole 50 (inner opening) which is communicated with and connected to the pressure introducing hole S4 (internal space) is a region that extends in the X-direction and is formed between the front-end inner surface 3bc of the side wall 3by and the point V at which the front-end face 3ba of the side wall 3bx intersects with the side wall inner surface 3bb of the side wall 3bx.

Reference letter IM is a virtual line that connects the point V and the point W and extends from the external space of the lid 3 toward the internal space C.

The virtual line intersects with the center line CL of the through hole 50 and coincides with a diagonal line of the through hole 50 (line connecting the point V and the point W).

Particularly, the protrusion 51 protrudes from the side wall 3by so that the virtual line IM cuts across the protrusion 51 (the wall surface 51a) that functions as a light shielding wall, that is, so that the wall surface 51a intersects with the virtual line IM.

Since the protrusion 51 of the lid 3 and the through hole 50 are configured so that the virtual line IM cuts across the protrusion 51 as mentioned above, even where light enters the internal space C from the external space through the through hole 50 along the virtual line IM, the light is shielded by the wall surface 51 a of the protrusion 51, and it is difficult for the light to reach the devices which are arranged in the internal space C.

In the embodiment, the distance from the side wall 3by to the end of the protrusion 51 is approximately 450 µm.

Furthermore, as described above, the width of the through hole 50 and the distance L between the side wall inner surface 3bb and the wall surface 51a are approximately 200 µm.

As long as light can be shielded by the wall surface 51a of the protrusion 51, the foregoing width and the distance are not particularly limited.

Additionally, a substantially rectangular corner is formed at the front-end outer surface 3bd (the point W), the front-end face 3ba (the point V), and the end of the protrusion 51 in FIG. 9A; however, the corner shape obtained by injection molding is not necessarily rectangular, and a corner having a rounded shape may be formed.

For this reason, the aforementioned width and the distance are suitably determined in consideration with errors in the distance obtained by injection molding or variations in configuration.

Subsequently, a constitution will be described in which the lid 3 that includes the above-mentioned pressure introducing hole S4 and the light shield R4 is connected to a pressure sensor module.
FIG. 9B is a cross-sectional view showing the lid 3 that includes the pressure introducing hole S4, and the light shield R4, and the pressure sensor module.

As shown in FIG. 9B, a pressure sensor module 1C has the internal space C defined by the package substrate 2 and the lid 3.

The pressure introducing hole S4 and the light shield R4 are formed in the lid 3.

A structural body Q is provided on the package substrate 2 in the internal space C.

The structural body Q is a structural body including a sensor, a circuit, pads, or the like which are provided on the package substrate 2 in the internal space C, for example, including the pressure sensing device 10, the integrated circuit device 20 (signal processing IC), the bonding pads 40, or the like which are described in the above-mentioned embodiment.

The position P4 of the top surface (functional surface) Q1 of the structural body Q is separated from the package substrate 2 by a height H2.

Here, the position P4 of the top surface Q1 means the position of the top surface of the device having a height that is highest in the pressure sensing device 10, the integrated circuit device 20 (signal processing IC), the bonding pads 40, and the like which are arranged in the internal space C.

As described in FIG. 8C, the stepped portion 61 is provided on the lid 3.

The position P1 of the stepped portion 61 is separated from the package substrate 2 by a height H1, and the height H1 is smaller than the height H2.

That is, the stepped portion 61 is formed at the position lower than the position P4 of the top surface Q1.

In other words, in the Z-direction the pressure introducing hole S4 is far from the top surface Q1.

As described above, as a result of providing the stepped portion 61, even where light enters the opening 50a of the through hole 50, it is difficult for the light to reach the top surface Q1 of the structural body Q that is arranged in the internal space C in addition to that the light is blocked by the pressure introducing hole S4 and the light shield R4.

Accordingly, light is prevented from entering the inside of the pressure sensor module 1C, and a variation in the output characteristics of the pressure sensing device or a faulty operation of the integrated circuit device can be prevented.

Moreover, even where the opening 50a of the through hole 50 is irradiated with light and the scattering of the incident light occurs in the pressure introducing hole S4 and the light shield R4, the irradiated area at which the scattered light narrows down, and the above-mentioned effect can be synergistically obtained.

Furthermore, as a result of making the inner wall surface of the pressure introducing hole S4 black, it is possible to prevent light from scattering.

In the aforementioned third embodiment, the constitution is described in which the through hole 50 is formed at the side wall 3bx extending in the X-direction and the protrusion 51 is formed at the side wall 3by extending in the Y-direction. However, a constitution may be adopted in which the through hole 50 is formed in the side wall 3by (first side wall) and the protrusion 51 is formed on the side wall 3bx (second side wall).

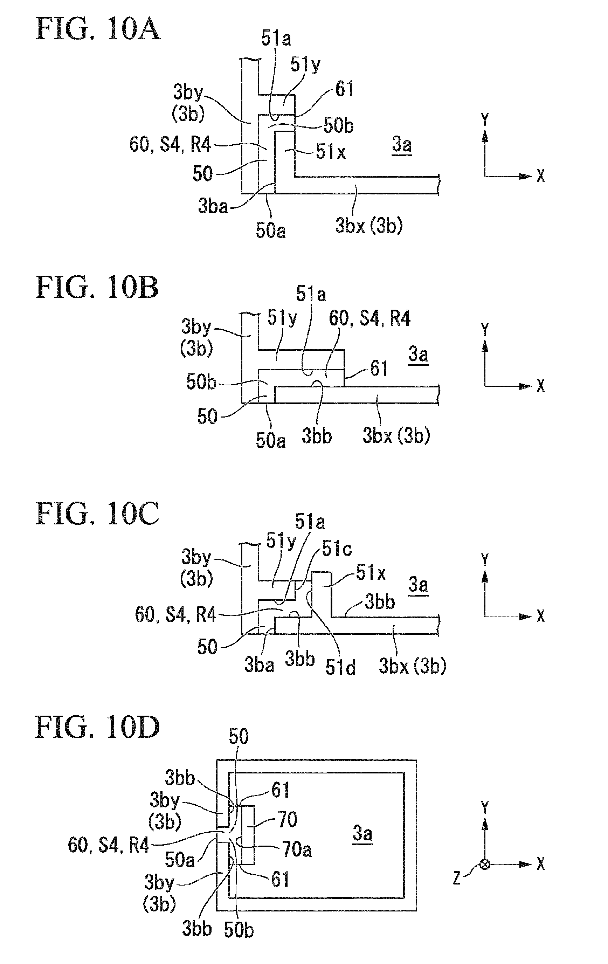

Next, with reference to FIGS. 10A to 10D which are enlarged plan views, modified examples 1 to 4 of a lid constituting a pressure sensor module according to the third embodiment will be described.

In the modified examples 1 to 4, identical symbols are used for the elements which are identical to those of the above-described third embodiment, and the explanations thereof are omitted or simplified here.

In the modified example 1 shown in FIG. 10A, the protrusion 51x (light shielding wall) is provided which extends from the front-end face 3ba of the side wall 3bx in parallel to the extending direction of the side wall 3by.

Furthermore, the protrusion 51y (light shielding wall) which has the wall surface 51a opposed to the end of the protrusion 51x is provided on the side wall 3by.

The configuration of the protrusion 51y is the same as that of the protrusion 51 of the aforementioned third embodiment.

That is, in the modified example 1, the protrusions are provided on the respective side wall 3bx and side wall 3by.

In the modified example 1, the through hole 50 that extends in the Y-direction is provided between the protrusion 51x and the protrusion 51y.

The space sandwiched between the wall surface 51a and the end of the side wall 3bx extends in the X-direction.

The through hole 50 and the space serves as the pressure introducing hole S4, the hole axis of the pressure introducing hole S4 is bent, and therefore, the light shield R4 is formed.

Moreover, even in the case where the pressure introducing hole S4 is configured by the through hole 50 and the protrusion 51y, the virtual line (refer to FIG. 9A) that coincides with the diagonal line of the through hole 50 cuts across the protrusion 51y.

Furthermore, the pressure introducing hole S4 is formed on the hole inner surface 60, that is, the stepped portion 61 is provided between the hole inner surface 60 and the upper wall 3a.

Also in the foregoing modified example 1, the same effect as that of the above-described third embodiment is obtained.

In the modified example 2 shown in FIG. 10B, the protrusion 51y (light shielding wall) is provided which is longer than the distance of the protrusion 51 of third embodiment.

The structure of the through hole 50 is the same as that of the third embodiment.

The space sandwiched between the wall surface 51a and the side wall inner surface 3bb extends in the X-direction.

The through hole 50 and the space serves as the pressure introducing hole S4, the hole axis of the pressure introducing hole S4 is bent, and therefore, the light shield R4 is formed.

Moreover, even in the case where the pressure introducing hole S4 is configured by the through hole 50 and the protrusion 51y, the virtual line (refer to FIG. 9A) that coincides with the diagonal line of the through hole 50 cuts across the protrusion 51y.

Furthermore, the pressure introducing hole S4 is formed on the hole inner surface 60, that is, the stepped portion 61 is provided between the hole inner surface 60 and the upper wall 3a.

Also in the foregoing modified example 2, the same effect as that of the above-described third embodiment is obtained.

In the modified example 3 shown in FIG. 10C, the protrusion 51x (light shielding wall) is provided which protrudes from the side wall inner surface 3bb at the position apart from the front-end face 3ba of the side wall 3bx and extends parallel to the extending direction of the side wall 3by.

Furthermore, the protrusion 51y (light shielding wall) which has the wall surface 51a opposed to the end of the protrusion 51x is provided on the side wall 3by.

The configuration of the protrusion 51y is the same as that of the protrusion 51 of the aforementioned third embodiment.

That is, in the modified example 3, the protrusions are provided on the respective side wall 3bx and side wall 3by.

Moreover, in the modified example 3, the through hole 50 that extends in the Y-direction is provided between the front-end face 3ba and the protrusion 51y.

A first space that is sandwiched between the wall surface 51a and the side wall inner surface 3bb extends in the X-direction.

Furthermore, the end 51c of the protrusion 51y faces the wall surface 51d of the protrusion 51x, and a second space is thereby formed.

The through hole 50, the first space, and the second space configures the pressure introducing hole S4.

The hole axis of the pressure introducing hole S4 is bent, that is, the light shield R4 is formed.

This means that the pressure introducing hole S4 and the light shield R4 are formed in an inverted S-shape.

Additionally, even in the case where the pressure introducing hole S4 is formed by the through hole 50 and the protrusions 51y and 51x, the virtual line (refer to FIG. 9A) that coincides with the diagonal line of the through hole 50 cuts across the protrusions 51y and 51x.

Furthermore, the pressure introducing hole S4 and the light shield R4 are formed on the hole inner surface 60, that is, the stepped portion 61 is provided between the hole inner surface 60 and the upper wall 3a.

Also in the foregoing modified example 3, the same effect as that of the above-described third embodiment is obtained.

In the aforementioned modified example 3, the pressure introducing hole S4 and the light shield R4 having a plane pattern formed in an inverted S-shape are explained; in other cases, the pressure introducing hole S4 and the light shield R4 may be configured by a labyrinth structure in which S-shaped or L-shaped patterns are repeatedly provided.

In the above-mentioned third embodiment and modified examples 1 to 3, a structure is described in which the pressure introducing hole S4 is formed at the corner of the lid 3.

In the modified example 4, a constitution will be described in which the pressure introducing hole S4 is provided in the side wall 3 of the lid 3.

In the modified example 4 shown in FIG. 10D, the through hole 50 is formed at a substantially center of the side wall 3by.

Moreover, a dividing wall 70 (light shielding wall) is provided at the position facing the through hole 50 and at the position apart from the side wall 3by in the internal space C.

Particularly, the dividing wall 70 is linearly formed at the position facing the opening 50b of the through hole 50 so as to extend in the Y-direction.

The dividing wall 70 is provided on the lid 3 so as to protrude from the upper wall 3a (in Z-direction).

Furthermore, in the modified example 4, the through hole 50 is provided so as to extend in the X-direction.

Two spaces which are sandwiched between the wall surface 70a of the dividing wall 70 and the side wall inner surface 3bb of the side wall 3by extend in the Y-direction.

The through hole 50 and the two spaces forms the pressure introducing hole S4.

The hole axis of the pressure introducing hole S4 is bent, that is, the light shield R4 is formed.

That is, the pressure introducing hole S4 and the light shield R4 is formed in a T-shape.

Moreover, even in the case where the pressure introducing hole S4 is configured by the through hole 50 and the dividing wall 70, the virtual line (refer to FIG. 9A) that coincides with the diagonal line of the through hole 50 cuts across the dividing wall 70.

Furthermore, the pressure introducing hole S4 and the light shield R4 are formed on the hole inner surface 60, that is, the stepped portion 61 is provided between the hole inner surface 60 and the upper wall 3a.

Also in the foregoing modified example 4, the same effect as that of the above-described third embodiment is obtained.

Particularly, in the modified example 4, a constitution is explained in which the through hole 50 is provided in the side wall 3by and the dividing wall 70 extends in the Y-direction; however, a structure may be adopted in which the through hole 50 is provided in the side wall 3bx and the dividing wall 70 extends in the X-direction.

In addition, in the modified example 4, the case is explained where the pressure introducing hole S4 and the light shield R4 are provided at the center of the side wall 3by; in this case, the through hole 50 is provided at any position of four the side walls 3b depending on the layout of the pressure sensing device 10 and the integrated circuit device 20 (signal processing IC) which are arranged on the package substrate 2 inside the internal space C.

Additionally, in the case where there is no space in which the pressure introducing hole S4 and the light shield R4 are provided on the side wall 3b, it is preferable that the configuration described in the third embodiment or the modified examples 1 to 3 be adopted.

Moreover, a through hole may be formed at a corner, and a dividing wall may be provided at the position corresponding to the through hole is formed at the corner.

That is, the positions of the light shielding wall and the through hole are suitably determined so as to form a desired space in the internal space C in accordance with the size or the arrangement (layout) of the pressure sensing device 10 and the integrated circuit device 20.

While preferred embodiments of the invention have been described and illustrated above, it should be understood that these are exemplary of the invention and are not to be considered as limiting. Additions, omissions, substitutions, and other modifications can be made without departing from the scope of the present invention. Accordingly, the invention is not to be considered as being limited by the foregoing description, and is only limited by the scope of the appended claims.

As an example, a constitution (for example, FIG. 3A) in which a pressure introducing hole is provided on the package substrate 2 may be combined with a lid structure that includes the light shielding wall and the through hole.

### Industrial Applicability

The invention is widely applicable to a pressure sensor module functioning as a pressure sensor for various usages, and an electronic device and an electronic apparatus which are provided with the foregoing pressure sensor module.

### DESCRIPTION OF REFERENCE NUMERAL

- 1A, 1B: pressure sensor module
- 2: substrate (package substrate)
- 3: lid
- 3b: side wall
- 3bx: side wall (first side wall)
- 3by: side wall (second side wall)
- 10: semiconductor pressure sensing device
- 11: semiconductor substrate
- 12: space (pressure reference chamber)
- 13: diaphragm
- 14: gauge resistor
- 15: insulating layer
- 16: first connection pad
- 17: pad-connecting wire
- 20: integrated circuit device (signal processing IC)
- 30: adhesive layer
- 40: bonding pad
- 45: external connection electrode
- 50: through hole
- 51, 51x, 51y: protrusion (light shielding wall)
- 60: hole inner surface
- 61: stepped portion
- 70: dividing wall (light shielding wall)
- C: internal space
- S1, S2, S3, S4: pressure introducing hole
- S1a, S2b, S3c: opening (pressure introducing hole)
- R1, R2, R3, R4: light shield (pressure introducing hole)

## Claims

1. A pressure sensor module comprising:
a substrate;
a lid connected to the substrate;
a semiconductor pressure sensing device and an integrated circuit device functionally connected to the semiconductor pressure sensing device, which are accommodated in an internal space surrounded by the substrate and the lid;
a pressure introducing hole that communicates the internal space to an external space; and
a light shield that is provided between the external space and the internal space and is formed so that a hole axis of the pressure introducing hole is bent.

2. The pressure sensor module according to claim 1, wherein
an opening of the pressure introducing hole that opens to the internal space is located at a region that does not face a functional surface of the semiconductor pressure sensing device and the integrated circuit device.

3. The pressure sensor module according to claim 1, wherein
the pressure introducing hole is formed to the side of the pressure sensor module.

4. The pressure sensor module according to claim 1, wherein
the lid has a through hole that communicates the external space to the internal space and a light shielding wall that is provided inside the lid and formed at a position facing the through hole.

5. The pressure sensor module according to claim 4, wherein
the lid has a first side wall and a second side wall, the through hole is provided in the first side wall, the light shielding wall is provided on the second side wall, and the pressure introducing hole is formed by the through hole and the light shielding wall.

6. The pressure sensor module according to claim 5, wherein
the light shielding wall is a protrusion that protrudes from the second side wall, and the protrusion is provided to cover the through hole provided on the first side wall.

7. The pressure sensor module according to any one of claims 4 to 6, wherein
the lid has an upper wall, a hole inner surface on which the pressure introducing hole is formed, and a stepped portion provided between the upper wall and the hole inner surface.

8. The pressure sensor module according to any one of claims 1 to 7, wherein
a color of an inner wall surface of the pressure introducing hole is black.

9. A lid comprising:
a through hole that communicates an external space to an internal space; and
a light shielding wall that is provided in the internal space and formed at a position facing the through hole.

10. The lid according to claim 9, further comprising a first side wall and a second side wall, wherein
the through hole is provided on the first side wall, the light shielding wall is provided on the second side wall, and a pressure introducing hole is formed by the through hole and the light shielding wall.

11. The lid according to claim 10, wherein
the light shielding wall is a protrusion that protrudes from the second side wall, and the protrusion is provided to cover the through hole provided on the first side wall.

12. The lid according to any one of claims 9 to 11, wherein
the lid has an upper wall, a hole inner surface on which the pressure introducing hole is formed, and a stepped portion provided between the upper wall and the hole inner surface.

13. The lid according to any one of claims 9 to 12, wherein
a color of an inner wall surface of the pressure introducing hole is black.
